# FASCICULE DE BREVET EUROPEEN

(11) **EP 2 212 934 B1**
(45) Date de publication et mention de la délivrance du brevet: **04.09.2019**
(21) Numéro de dépôt: 08841919.7
(22) Date de dépôt: 24.10.2008
(51) Int. Cl.: H01L 51/40, C30B 29/54, C30B 11/00, H01L 51/05

(54) **Réalisation d'une couche mince en matériaux semiconducteur organique moléculaire**
Herstellung einer dünnen Schicht eines organischen Halbleiters
Formation of a thin film of molecular organic semiconductor material

(30) Priorité: 24.10.2007 FR 0707452
(43) Date de publication de la demande: 04.08.2010
(73) Titulaire: Centre National de la Recherche Scientifique (CNRS) Etablissement Public à Caractère Scientifique et Technologique, 75016 Paris (FR); Commissariat à l'Énergie Atomique et aux Énergies Alternatives, 75015 Paris (FR)
(72) Inventeur: RANNOU, Patrice, F-38320 Eybens (FR); GREVIN, Benjamin, F-38470 Vinay (FR)
(74) Mandataire: Lavoix
(86) Numéro de dépôt international: PCT/EP2008/064476
(87) Numéro de publication internationale: WO 2009/053473

(56) Documents cités:
- WO-A-2005/104265
- US-A1- 2007 117 298
- US-B1- 6 608 205
- N. STINGELIN-STUTZMANN ET AL.: "Organic thin film electronics from vitreous solution-processed rubrene hypereutectics" NATURE MATERIALS, vol. 4, août 2005 (2005-08), pages 601-606, XP002482589 cité dans la demande
- LAUDISE R A ET AL: "GROWTH OF ALPHA-HEXATHIENYL BY A MICRO MELT TECHNIQUE" JOURNAL OF CRYSTAL GROWTH, ELSEVIER, AMSTERDAM, NL, vol. 152, no. 3, 1 juillet 1995 (1995-07-01), pages 241-244, XP000626683 ISSN: 0022-0248

## Description

L'invention concerne un procédé de réalisation de couche mince de matériau semi-conducteur organique (MSCO) moléculaire destinée à être intégrée dans un dispositif pour des applications en électronique ou opto-électronique, afin que ledit matériau ait une organisation structurale souhaitée (entre l'état amorphe et l'état cristallin) favorisant lesdites applications.

Les semi-conducteurs organiques (molécules et macromolécules pi-conjuguées) sont utilisés depuis le milieu des années 80 comme couches actives pour la réalisation de divers composants électroniques comme des diodes (e.g. diodes électroluminescentes organiques OLEDs ; diodes électroluminescentes à base de polymères PLEDs), des transistors à effet de champ (e.g. transistors à effet de champ organiques OFETs ; transistors à effet de champ à base de polymères PFETs ; transistors à effet de champ à base de monocristaux organiques SCOFETs), des cellules photovoltaïques organiques ou des lasers organiques.

Il est connu de réaliser de tels MSCO en couche mince, par voie humide, c'est à dire que le matériau est mis en oeuvre dans un solvant (solution, dispersion, encre etc..).

Cette technique, particulièrement utilisée dans le cas de polymères semi-conducteurs, ne permet cependant pas d'obtenir des MSCO monocristallins en couches minces.

Par ailleurs, l'utilisation d'un solvant peut entraîner des problèmes inhérents de toxicité, de volatilité et d'inflammabilité, et de contamination.

Il est aussi connu de réaliser de tels matériaux en couche mince, par des techniques d'évaporation sous vide.

Ces techniques ne peuvent néanmoins être mises en oeuvre que pour des molécules semi-conductrices évaporables - ce qui n'est pas le cas, par exemple, de la plupart des polymères - et relativement petites - ce qui n'est pas le cas, par exemple, des molécules de conformations complexes. En particulier, les conditions d'évaporation de certaines molécules pour l'obtention de domaines cristallins se situent à la limite du démouillage de ces molécules sur un substrat donné. C'est le cas par exemple pour le MSCO moléculaire 5,6,11,12-tétraphényl-naphtacène, appelé également rubrène.

De plus, les techniques d'évaporation nécessitent des vides poussés, ce qui est contraignant et coûteux.

En outre, même si les couches minces de certains MSCO par évaporation peuvent être mieux structurées que les couches obtenues par voie humide, il reste en général très difficile, voire exceptionnel, d'obtenir des couches minces monocristallines à grande échelle et sans perte massive de matériau.

Ce même problème se pose d'ailleurs pour l'obtention des couches minces par voie humide.

D'autre part, un autre problème que rencontrent ces techniques antérieures, est la difficulté de contrôler avec précision le degré d'organisation structurale finalement obtenu.

Or, le contrôle de la qualité structurale de ces couches minces est un point clé qui régit les propriétés de transport électronique et les performances des dispositifs.

De WO 2005/104265 et de «Organic thin-film electronics from vitreous solution-processed rubrene hypereutectics» (N. Stingelin-Stutzmann et Coll., dans Nature Materials, Vol.4, Août 2005), il est également connu de réaliser une couche mince comportant un MSCO polycristallin en fondant tout d'abord une composition comprenant notamment le MSCO, puis en refroidissant cette composition liquide pour provoquer une solidification du matériau de la couche mince sous forme polycristalline.

Le document US 6,608,205 concerne quant à lui la réalisation de couches minces de matériaux organiques qui ne sont pas semi-conducteurs.

Par rapport aux techniques existantes, un objectif de l'invention est d'augmenter les performances de dispositifs d'électronique et opto-électronique organique en contrôlant le degré d'organisation des couches minces actives à base de MSCO moléculaires.

Un autre objectif de l'invention est l'obtention de telles couches minces de façon contrôlée et reproductible.

Un autre objectif de l'invention est de réaliser ces couches minces sur de grandes surfaces (plaquettes ou "wafers" de 200 à 300 mm de diamètre).

Un autre objectif de l'invention est de réaliser de telles couches minces simplement et à bas coût, de sorte à être transposable à une échelle industrielle.

Afin d'atteindre ces objectifs, l'invention propose, selon un premier aspect, un procédé de réalisation d'une couche mince en MSCO moléculaire destinée à être intégrée dans un dispositif pour des applications en électronique ou opto-électronique, comprenant les étapes suivantes:
(a) fournir une quantité déterminée du MSCO moléculaire sous forme d'un fondu (e.g. état du MSCO moléculaire à une température supérieure à son point de fusion (Pf)) à la surface d'un support de sorte à former une couche mince, le MSCO moléculaire étant à une température supérieure à son point de fusion;
(b) refroidir selon un profil de température déterminé pour provoquer une solidification de la couche mince;
caractérisé en ce que la température de la surface du support est supérieure ou égale au point de fusion du MSCO moléculaire au moment de mettre en oeuvre l'étape (a), et en ce que le profil de température de l'étape (b) comprend :
- une première partie correspondant à un refroidissement contrôlé et suffisamment lent du MSCO moléculaire fondu jusqu'à une température voisine de la température de cristallisation du MSCO moléculaire pour ne faire apparaître qu'un seul germe dans la couche mince sous forme fondue; et
- une deuxième partie correspondant à un refroidissement contrôlé de sorte qu'au moins un domaine monocristallin croisse à partir de ce germe, la couche mince finalement obtenue étant monocristalline.

D'autres caractéristiques optionnelles de ce procédé sont:
- ce procédé est mis en oeuvre sous atmosphère inerte;
- le procédé comprend en outre, avant l'étape (a), la fourniture dudit MSCO moléculaire sous une forme solide, et le chauffage de ce MSCO moléculaire à une température supérieure à son point de fusion;
- l'étape (b) comporte, de préférence, l'application d'une pression sur la surface du MSCO moléculaire fondu afin de le répartir en couche mince sur la surface du support;
- l'étape (a) comprend:
   ∘ le logement dudit support dans le réceptacle d'un four;
   ∘ un étalement du MSCO moléculaire fondu sur le support;
   ∘ une contrainte exercée sur le MSCO moléculaire fondu pour le répartir en une couche mince d'épaisseur uniforme sur la surface du support.
- le refroidissement est contrôlé lors de l'étape (b) par des moyens de régulation de la température au contact de la couche mince, asservis à un système de régulation de température du four ;
- le MSCO moléculaire est choisi parmi les familles des MSCO moléculaires suivantes:
- une première famille constituée des composés **(3)**, **(4)**, **(5)** et **(6)** 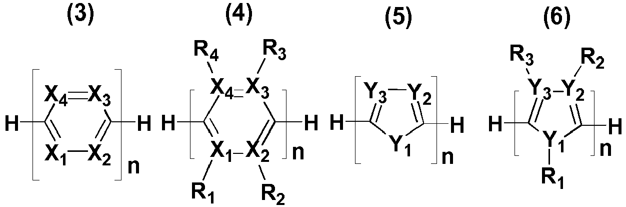 **avec n< 20 et Mw< 5000 g.mol⁻¹**
   (Mw = masse moléculaire) (avantageusement n est un entier compris entre 2 et 20)
   - avec un premier motif (tel que **(3)** et **(4)**) où X₁ = X₂ = X₃ = X₄ = C (ou CH dans le cas de la molécule (3)) définissant par exemple le biphényle (n = 2), le terphényle (n = 3), le quaterphényle (n = 4), le quinquephényle (n = 5), le sexiphényle (n = 6) ;
   - avec un deuxième motif (tel que **(5)** et **(6)**) où Y₁= S, Y₂ = Y₃ = C (ou CH dans le cas de la molécule (5)) définissant par exemple le α-bisthiényle (n = 2), α-terthiényle (n = 3), α-quaterthiényle (n = 4), α-quinquethiényle (n = 5), α-sexithiényle (n = 6) ;

Pour cette première famille, R1, R2, R3 et R4 sont tels que définis ci-après et de préférence sont choisis parmi un atome d'hydrogène, un phényle, un aralkyle (tel qu'un benzyle) et une chaîne linéaire ou ramifiée, saturée ou insaturée, comportant de 1 à 6 atomes de carbone.
- une deuxième famille constituée des composés **(9)**, **(10)**, **(11)**, **(12)**, **(13)**, **(14)**, **(15)** et **(16)** 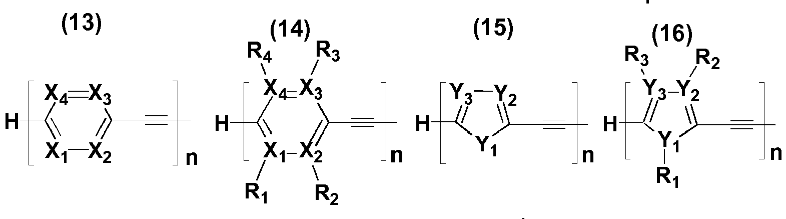 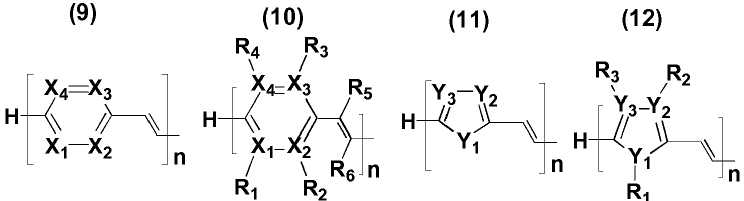 **avec n< 20 et Mw< 5000 g.mol⁻¹**
   (avantageusement n est un entier compris entre 2 et 20)
   - avec un premier motif (tel que **(9)-(10)** et **(13)-(14))** où X₁ = X₂ = X₃ = X₄ = C (ou CH dans le cas des molécules (9) et (13)) définissant par exemple, les oligo(1,4-phénylène-vinylène)s ou les oligo(1,4-phénylène-éthynylène)s en fonction de la répétition n du motif ;
   - avec un deuxième motif (tel que **(11)-(12)** et **(15)-(16))** où Y₁ = S, Y₂ = Y₃ = C (ou CH dans le cas des molécules (11) et (15)) définissant par exemple, les oligo(2,5-thiénylène-vinylène)s et les oligo(2,5-thiénylène-éthynylène)s

Pour cette deuxième famille, R1, R2, R3 et R4 sont tels que définis ci-après et de préférence sont choisis parmi un atome d'hydrogène, un phényle, un aralkyle (tel qu'un benzyle) et une chaîne linéaire ou ramifiée, saturée ou insaturée, comportant de 1 à 6 atomes de carbone.
- une troisième famille constituée des composés **(17)**, **(18)**, **(19)**, et **(20)** 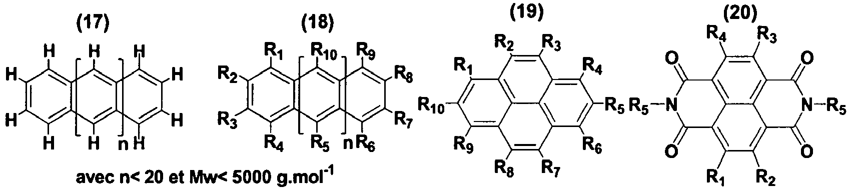 (avantageusement n est un entier compris entre 0 et 20)
   - avec un premier motif (tel que **(17)**) définissant par exemple le naphtalène, l'anthracène, le tétracène, le pentacène, ou l'hexacène ;
   - avec un deuxième motif (tel que **(18)**) où R₅ = R₁₀ = phényle définissant par exemple le 9,10-diphenylanthracène, le 5,12-diphénylnaphtacène, ou le 5,6,11,12-tétraphénylnaphtacène encore appelé rubrène en fonction de la répétition n du motif;
   - avec un troisième motif (tel que **(19)**) définissant par exemple le pyrène, le 1,3,6,8-tetraphénylpyrène, 1,3,6,8-tetrathiénylpyrène, le chrysène, le pérylène, le coronène, le terrylène, l'ovalène, le quaterrylène, ou encore des fullerènes C₆₀, C₇₀, C₇₆, C₇₈, C₈₄ ;
   - avec un quatrième motif de type (tel que **(20)**) définissant par exemple les diimides d'acide naphtalène-1,4,5,8-tétracarboxylique, diimides d'acide anthracène-2,3,6,7-tétracarboxylique , diimides d'acide pérylène-3,4,9,10-tétracarboxylique,

Pour cette troisième famille, les radicaux R1 à R10 sont tels que définis ci-après et de préférence sont choisis parmi un atome d'hydrogène, un phényle, un aralkyle (tel qu'un benzyle) et une chaîne linéaire ou ramifiée, saturée ou insaturée, comportant de 1 à 6 atomes de carbone.
- le MSCO moléculaire pourra également être choisi pour comprendre :
   - des groupes aryle, à savoir avec le motif de base M1 (voir ci-après) où X₁ = X₂ = X₃ = X₄ = C ; et/ou
   - des groupes hétéroaryle comprenant le motif de base M1 où X1, X₂, X₃ et X₄ sont choisis parmi C, O, S, N, P, et B et de préférence sont choisis parmi C, N et P, et encore de préférence sont choisis parmi C et N, et /ou
   - des groupes de types hétérocycliques comprenant le motif de base M2 (voir ci-après) où Y₁ = O, ou S, ou N, ou P, ou B, (de préférence Y₁ = O, S ou N et avantageusement Y₁ = S) et où Y₂ et Y₃ sont choisis parmi C, O, S, N, P, et B et de préférence sont choisis parmi C, N et P, et encore de préférence sont choisis parmi C et N.

Selon un deuxième aspect, l'invention propose un procédé de réalisation d'un transistor à effet de champ organique, tel qu'un OFET, caractérisé en ce qu'il comprend les étapes suivantes:
(a) la fourniture d'un substrat «pré-patterné», le substrat «pré-patterné» comportant une grille, un diélectrique de grille, des électrodes sources et des électrodes drains;
(b) la réalisation d'une couche mince en MSCO moléculaire monocristallin conformément au procédé selon l'invention, le substrat «pré-patterné» étant ledit support et la couche mince étant la couche active du transistor.

D'autres caractéristiques, buts et avantages de l'invention pourront être lus dans la description qui suit, donnée ici à titre d'exemple non limitatif, et illustrée par les figures suivantes:
Les figures 1A à 1F représentent différentes étapes d'un procédé de réalisation d'un OFET selon l'invention.
Les figures 2A à 2N représentent des photos prises par thermomicroscopie optique sous polariseurs croisés (TMOP) en mode réflexion, d'un dispositif OFET lors de la réalisation d'une couche mince monocristalline en rubrène selon l'invention.
Les figures 3A à 3G représentent des photos prises par TMOP en mode transmission, d'une surface en verre supportant une couche mince monocristalline en α-terthiényle selon l'invention.
La figure 4 représente une photo prise par TMOP en mode réflexion, d'un OFET ayant une couche active monocristalline en rubrène réalisée selon l'invention.
La figure 5 représente les caractéristiques Courant de Drain (I_{D} [nA])-Tension de Drain (V_{D}[V]) du dispositif selon la figure 4.
La figure 6 représente la mobilité des porteurs de charges (en régime de saturation: µₛₐₜ[cm².V⁻¹.s⁻¹]) pour une Tension Drain (V_{D} [V]) de -30V en fonction de la tension de la grille (V_{G} [V]) du dispositif selon la figure 4.

Les MSCO moléculaires utilisés peuvent se présenter sous la forme de poudres plus ou moins divisées, ou sous toute autre forme solide.

Un MSCO moléculaire est un MSCO constitué de "petites molécules", c'est à dire d'architectures moléculaires (1D, quasi-1D, 2D et 3D) ayant une masse moléculaire (Mw [g.mol⁻¹]) inférieure ou égale à environ 5 000 g.mol⁻¹, comportant un nombre d'unité de répétition (n) proche de 20, et de préférence, inférieure ou égale à 20 (e.g. des oligomères) et présentant la caractéristique d'être préférentiellement congruent au point de fusion. Les Polymères Semi-Conducteurs Organiques (PSCO: architectures macromoléculaires où n> 20), les Copolymères Semi-Conducteurs Organiques (CSCO: architectures macromoléculaires où n> 20) et les Matériaux Semi-Conducteurs Organiques Mésomorphes (MSCOM) sont donc exclus du champ de l'invention. Le MSCO moléculaire peut être tout matériau organique (c'est à dire comprenant au moins du carbone et plusieurs liaisons carbone-carbone simples ou doubles, préférablement de l'hydrogène et des liaisons carbone-hydrogène) qui possède des propriétés semi-conductrices.

Par exemple, le MSCO moléculaire, qui comprendra des motifs de base M1 et M2, à savoir: 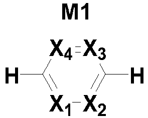 **avec X1, X2, X3 et X4**
**= C, ou O, ou S, ou N, ou P, ou B** 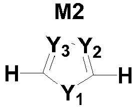 **avec Y1= O, ou S, ou N, ou P, ou B**
**avec Y2 et Y3=**
**C, ou O, ou S, ou N, ou P, ou B**
pourra être choisi parmi les trois familles suivantes:
De préférence, X1, X2, X3 et X4 sont choisis parmi C, N et P, et avantageusement parmi C et N.

Y2 et Y3 seront avantageusement choisis parmi C, N et P, et de préférence parmi C et N.
- Famille 1 (MSCO à architecture linéaire à base des motifs M1 et M2) illustrée ci-dessous et comprenant des oligomères **(3)** et **(5)** 1D/quasi-1D et leurs dérivés substitués **(4)** et **(6)** avec des substituants R₁, R₂, R₃ et R₄, tels que définis ci-après. 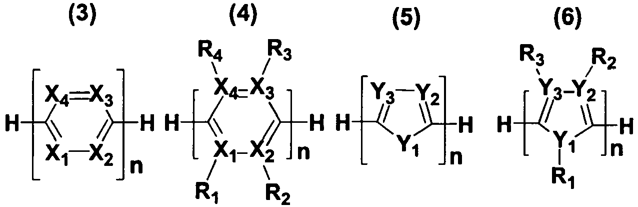 **avec n< 20 et Mw< 5000 g.mol⁻¹**
   (avantageusement n est un entier compris entre 2 et 20)
- Famille 2 (MSCO à architecture linéaire "mixtes" à base des motifs M1 et M2) illustrée ci-dessous et comprenant des co-oligomères **(9)**, **(11)**, **(13)** et **(15)** 1D/quasi-1D "mixtes" et leurs dérivés "mixtes" substitués **(10)**, **(12)**, **(14)** et **(16)** avec des substituants R₁, R₂, R₃ et R₄, tels que définis ci-après. 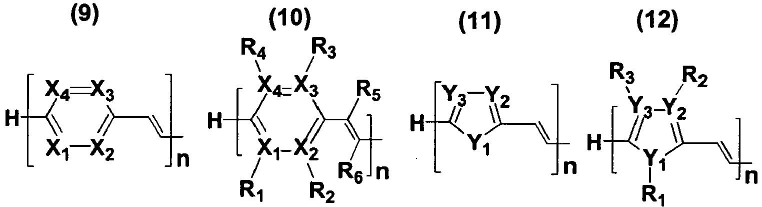 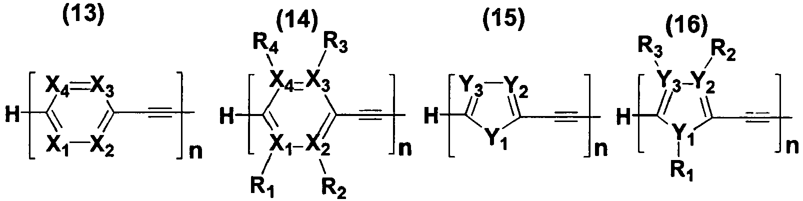 **avec n< 20 et Mw< 5000 g.mol⁻¹**
   (avantageusement n est un entier compris entre 2 et 20)
- Famille 3 (MSCO à architectures quasi-1 D/2D et 2D-3D à base des motifs M1 et M2 représentés dans le cas où X₁ = X₂ = X₃ = X₄ = C) illustrée ci-dessous et comprenant des structures polycycliques/polyhétérocycliques (ces dernières structures ne sont pas représentées ici) en anneaux fondus **(17)** et quasi-1 D/2D et leurs dérivés **(18)**, **(19)** et **(20)** 2D-3D substitués 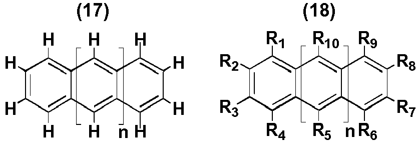 **avec n< 20 et Mw< 5000 g.mol⁻¹** 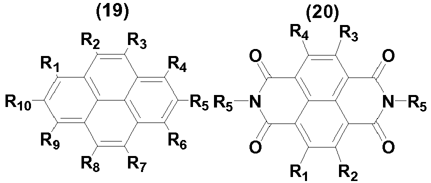 (avantageusement n est un entier compris entre 0 et 20, et r1 à R10 sont tels que définis ci-après)

Un MSCO moléculaire utilisable dans le cadre de l'invention peut aussi comprendre des groupes aryle (motif de base M1 avec X₁ = X₂ = X₃ = X₄ = C) et/ou hétéroaryle (motif de base M1 avec X₁, X₂, X₃, X₄ choisis parmi C, O, S, N, P, et B et de préférence choisis parmi C, N et P et encore de préférence choisis parmi C et N) et /ou de types hétérocycliques (motif de base M2 avec Y₁ choisi parmi O, S, N, P, et B et avantageusement parmi O, S et N et de préférence = S, et Y₂ et Y₃ choisis parmi C, O, S, N, P, et B et de préférence parmi C, N et P, et encore de préférence choisis parmi C et N). Les cas où X₁ et/ou X₂ et/ou X₃ et/ou X₄ = O et Y₂ et/ou Y₃ = O sont exclus.

Le terme aryle inclut ici les composants polycycliques en anneau fondu contenant au moins un anneau aromatique plein éventuellement substitué par un ou plusieurs groupes R₁, R₂, R₃, R₄, R₅, R₆, R₇, R₈, R₉ et R₁₀ tels que, par exemple, de type cyano, amino, fluoro, chloro, bromo, iodo, nitro, phényle, hydroxy, sulfo, alkyle C₁-₂₀, alcényle C₂-₂₀, alcynyle C₂-₂₀, ester (i.e. -CO₂-R^{a} où R^{a} est sélectionné parmi: alkyle C₁₋₂₀ non substitué, alcényle ou alcynyle; et d'aralkyle tels que définis ici), ester d'alkyle (i.e. -R^{b1}-CO₂-R^{a1} où R^{a1} est tel que défini pour R^{a} et R^{b1} est sélectionné parmi: alkyle C₁₋₂₀, alcényle C₂-₂₀, alcynyle C₂-₂₀; et aralkyle tels que définis ici), alcoxy C₁₋₂₀, amide (i.e. -CONR^{b}R^{c} où R^{b} et R^{c} sont indépendamment sélectionnés parmi: l'hydrogène; un alkyle C₁₋₂₀ non substitué, un alcényle C₂-₂₀ ou un alcynyle C₂-₂₀; et des groupes aralkyle tels que définis ici) et des alcynylaryles (i.e. -CC-aryle-R^{c1} où R^{c1} est sélectionné parmi: l'hydrogène, un alkyle C₁₋₂₀ non substitué, un alcényle C₂-₂₀ ou un alcynyle C₂-₂₀ ; et des groupes aralkyle tels que définis ici).

Avantageusement, les substituants R₁ à R₁₀ sont choisis, indépendamment les uns des autres, parmi un atome d'hydrogène, un phényle, un aralkyle (tel qu'un benzyle) et une chaîne linéaire ou ramifiée, saturée ou insaturée, comportant de 1 à 6 atomes de carbone.

Le terme "hétéroaryle" tel qu'utilisé ici se réfère aux composés contenant un cycle aromatique ou non aromatique en anneau fondu ou non fondu polyclique et monocyclique, ces composés contenant par ailleurs au moins un hétéroatome tel que, par exemple, un azote, un soufre ou un oxygène ou une combinaison d'entre eux dans l'un des anneaux, et dans lequel au moins un des anneaux est aromatique. Le ou les anneaux comprenant l'hétéroatome peut comprendre trois, quatre, cinq, six, sept ou huit éléments. Le terme "hétéroaryle" est destiné à inclure des composés qui comprennent partiellement ou entièrement des anneaux saturés, en outre des anneaux aromatiques. L'hétéroatome peut être situé dans les anneaux partiellement ou entièrement saturés ou dans l'anneau aromatique.

Le terme "hétéroaralkyle" tel qu'utilisé ici se réfère à un alkyle C₁-₂₀ substitué par des hétéroaryles (e.g. pyrazolylméthyle).

Les composés hétéroaryles peuvent optionnellement être substitués par des groupes alkyles, alkaryles ou des groupes aryles tels que définis au-dessus ou avec un ou plusieurs des autres groupes sélectionnés notamment parmi les cyano, amino, fluoro, chloro, bromo, iodo, nitro, phényle, hydroxy, sulfo, thiol, ester (ie. -CO₂-R^{d} où R^{d} est sélectionné parmi: un alkyle C₁₋₆ non substitué, un alcényle ou un alcynyle; et de l'aralkyle tels que définis ici), amide (i.e. -CONR^{e}R^{f} où R^{e} et R^{f} sont indépendamment sélectionné parmi : l'hydrogène; un alkyle C₁₋₆ non substitué, un alcényle C₁₋₆ ou un alcynyle C₁₋₆ ; et un aralkyle C₁₋₆ tels que définis ici).

Le terme "alkyle", tel qu'utilisé ici, inclut une chaîne droite et, pour les groupes alkyles contenant trois ou plus atomes de carbone, ramifiés et aussi des groupes cycloalkyles. Des exemples d'alkyles à chaîne droite incluent le méthyle, l'éthyle, le propyle, le butyle, le pentyle et l'hexyle. Des exemples d'alkyles ramifiés incluent l'isopropyle, l'isobutyle, et le *tert*-butyle. Des exemples de groupes cycloalkyles incluent le cyclopropyle, le cyclobutyle, le cyclopentyle et le cyclohéxyle.

Dans le cadre de l'invention, les groupes alkyles préférés sont ceux présentant de 1 à 20 atomes de carbone, et plus préférentiellement de 2 à 15, et idéalement de 4 à 12 atomes de carbone. Lorsque le groupe alkyle est un méthyle, on préfère qu'il soit substitué avec un groupe aryle et/ou un groupe hétéroaryle sur ces positions ortho ou méta. Pour les groupes alkyles contenant trois ou plus d'atomes de carbone, on préfère les isomères à structure en forme de branches.

Les groupes alkyles peuvent optionnellement être substitués avec, par exemple, des groupes aryles (tel que le phényle), et aralkyles et/ou un ou plusieurs groupes tels que, par exemple, cyano, amino, fluoro, chloro, bromo, iodo, nitro, hydroxy, sulfo, thiol, ester, (à savoir -CO₂-R^{g} où R^{g} est sélectionné parmi: un alkyle C₁₋₆, un alcényle C₁₋₆ ou un alcynyle C₁₋₆ non-substitué; et un aralkyle ou un aryle, comme défini ici), alcoxy C₁₋₆ et amide (ie, -CONR^{h}Rⁱ où R^{h} et Rⁱ sont sélectionnés indépendamment parmi: l'hydrogène; un alkyle C₁₋₆, un alcényle C₁₋₆ ou un alcynyle C₁₋₆ non-substitué ; et un aralkyle ou un aryle comme défini ici). Des groupes alkyles peuvent être substitués dans la chaîne alkyle par un ou plusieurs hétéroatomes sélectionnés parmi O, S et N.

Les termes "alcényle" et "alcynyle" sont définis de manière similaire au terme "alkyle", sauf que ces groupes contiennent au moins deux atomes de carbone et une ou plusieurs, de préférence une, liaison carbone-carbone double ou triple, respectivement.

Le terme "aralkyle" tel qu'utilisé ici se réfère à des alkyles de type C₁ à C₂₀ substitués avec des groupes aryles (exemple, benzyle).

Des exemples préférés de MSCO incluent des polyacènes tels que le naphtacène, le dibenzonaphtacène, le tétrabenzonaphtacène, le pentacène, l'hexacène, l'heptacène, le dibenzopentacène, le tétrabenzopentacène, le pyrène, le dibenzopyrène, le chrysène, le pérylène, le coronène, le terrylène, l'ovalène, le quaterrylène et les dérivés pour lesquels certains atomes de carbone des polyacènes sont substitués avec des atomes tels que N, S et O avec un groupe fonctionnel comme un groupe carbonyle ou un groupe carboxyle, par exemple, des diimides d'acides tétracarboxyliques tels que le diimide d'acide naphtalène-1,4,5,8-tétracarboxylique et des diimides d'acides anthracène-tétracarboxyliques comme les diimides d'acide anthracène-2,3,6,7-tétracarboxylique, des fullerènes comme C₆₀, C₇₀, C₇₆, C₇₈ et C₈₄, des nanotubes en carbone tels que le SWNT (selon l'expression anglo-saxonne «Single-Walled Carbon Nanotube») et des produits de condensation polycycliques décrits avec plus de détails dans la publication de demande de brevet japonais N°. 11-195790.

Des matériaux préférés sont des composés aromatiques polycycliques condensés tels que le naphtacène, le dibenzonaphtacène, le tétrabenzonaphtacène, les fullerènes, des diimides d'acides tétracarboxyliques cycliques condensés de composés à anneaux fondus condensés, et des 20-métallophtalocyanines.

Selon un mode de réalisation, le matériau semi-conducteur organique comprend un système à anneau fondu polycyclique.

Le système à anneau fondu polycyclique est optionnellement substitué avec un ou plusieurs groupes sélectionnés parmi: un aryle; un alcynylaryle; un alkyle C₁₋₂₀ ; un alcényle C₂-₂₀ ; un alcynyle C₂-₂₀ ; un aralkyle C₁-₂₀; un alcoxy C₁-₂₀ ; et -CCh-R^{j} où R^{j} est sélectionné parmi: un alkyle C₁₋₂₀ non substitué, un alcényle C₂₋₂₀ et un alcynyle C₂₋₂₀, ledit un ou plusieurs groupes aryles et/ou alcynylaryles et/ou aralkyles étant optionnellement substitué sur le cycle aromatique par un ou plusieurs groupes sélectionnés parmi: un phényle; un alkyle C₁-₂₀; un alcényle C₂-₂₀ ; un aralkyle C₁-₂₀; un alcoxy C₁-₂₀ ; et -CO₂-R^{k} où R^{k} est sélectionné parmi : un alkyle C₁₋₂₀ non substitué d' alcényle C₁-₂₀ et d'alcynyle C₂-₂₀.

D'autres substituants optionnels pour le système à anneau fondu polycyclique incluent les groupes cyano, amino, fluoro, chloro, bromo, iodo, nitro, hydroxy, sulfo, thiol et amide (i.e. -CONR^{l}R^{m} où R^{l} et R^{m} sont indépendamment sélectionnés parmi: l'hydrogène; un alkyle C₁₋₆ non substitué d'alcényle, d'alcynyle ; un aryle, un aralkyle).

Dans un mode de réalisation de l'invention, le matériau semi-conducteur organique comprend un système à anneau fondu polycyclique comportant deux à douze, plus préférentiellement quatre à dix, et idéalement six à huit anneaux aromatiques dans lesquels les anneaux aromatiques sont optionnellement substitués comme décrit ici.

Préférentiellement, les anneaux aromatiques sont de type C₆, par exemple des anneaux phényles.

Dans un mode de réalisation, le matériau semi-conducteur organique (MSCO) comprend un système d'anneau fondu polycyclique ayant la formule suivante **(18)** : 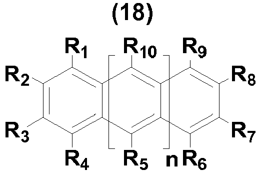 où n est un entier compris entre 0 et 20, préférentiellement entre 1 et 6; et R₁, R₂, R₃, R₄, R₅, R₆, R₇, R₈, R₉ et R₁₀ sont indépendamment sélectionnés parmi le groupe consistant en : l'hydrogène; un aryle; un alcynylaryle; un alkyle C₁-₂₀; alkyle non substitué d'alcényle C₁-₂₀ et C₂-₂₀ ; un alcynyle C₂-₂₀ ; un aralkyle C₁-₂₀; un alcoxy C₁-₂₀ ; et -CO₂-R^{o} où R^{o} est sélectionné parmi: un alkyle non substitué d'alcényle C₁-₂₀ et C₂-₂₀, d'alcynyle C₂-₂₀, d'aralkyle C₁-₂₀ ou d'alcoxy C₁-₂₀.

De préférence, R₅ et R₁₀ sont indépendamment sélectionnés parmi l'hydrogène et les aryles, optionnellement substitué avec un ou plusieurs groupes alkyles C₁-₂₀, préférentiellement C₂-₁₁. Tout particulièrement, les groupes aryles sont préférentiellement des groupes phényles.

Dans un mode de réalisation, R₁, R₂, R₃, R₄, R₆, R₇, R₈ et R₉ sont tous de l'hydrogène et R₅ et R₁₀ sont sélectionnés parmi l'hydrogène, un aryle et un alcynylaryle, où les groupes aryles et alcynylaryles sont optionnellement substitués avec un ou plus groupes alkyles C₁-₂₀, préférentiellement C₂-₁₀. Préférentiellement, R₅ et R₁⁰ sont des aryles et/ou des alcynylaryles C₂-₄. Tout particulièrement, les groupes aryles sont préférentiellement des groupes phényles.

Lorsque n> 1, chaque ensemble de R₅ et R₁₀ peut être le même ou différent. Avantageusement, le matériau semi-conducteur organique est un composé à anneau fondu polycyclique sélectionné parmi: un diphénylanthracène, optionnellement substitué avec un ou plusieurs groupes alkyles C₁-₂₀, préférentiellement pour toute position de l'anneau aromatique non fondu; un hexaphénylnaphtacène optionnellement substitué avec un ou plusieurs groupes alkyles C₁-₂₀, préférentiellement pour toute position de l'anneau aromatique non fondu; un tétraphénylnaphtacène, optionnellement substitué avec un ou plusieurs groupes alkyles C₁-₂₀, préférentiellement pour toute position de l'anneau aromatique non fondu; un bis(phényléthynyl)naphtacène optionnellement substitué avec un ou plusieurs groupes alkyles C₁-₂₀, préférentiellement pour toute position de l'anneau aromatique non fondu; un hexaphénylpentacène optionnellement substitué avec un ou plusieurs groupes alkyles C₁-₂₀, préférentiellement pour toute position de l'anneau aromatique non fondu; et un diphénylnaphtacène, optionnellement substitué avec un ou plusieurs groupes alkyles C₁-₂₀, préférentiellement pour toute position de l'anneau aromatique non fondu. Dans un mode de réalisation préféré, les groupes alkyles sont des groupes alkyles C₄-₁₂.

On préfèrera que le composé en anneau polycyclique soit substitué à une à quatre positions, préférentiellement de deux à trois positions. On préférera également que les positions soient dans des anneaux aromatiques non fondus.

Dans un mode de réalisation particulièrement préférentiel, le matériau semiconducteur organique est sélectionné parmi le 5,6,11,12-tétraphénylnaphtacène **(21)** (rubrène), le 5,12-diphénylnaphtacène **(22)** et le 9,10-diphénylanthracène **(23).** Ces composés peuvent être optionnellement substitués avec plusieurs groupes alkyles C₁₋₂₀, préférentiellement C₄₋₁₂, à chacune des positions de l'anneau aromatique non fondu.

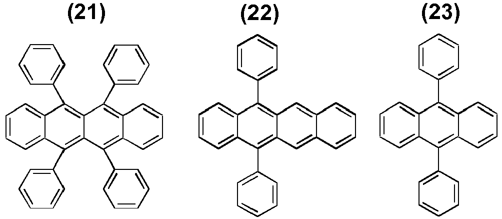

Dans un mode de réalisation de l'invention, les matériaux semi-conducteurs organiques sont le 5,6,11,12-tétraphénylnaphtacène (rubrène) **(21)** et le 5,11-bis-(4-*tert*-butylphényl)-6,12-diphénylnaphtacène **(24).** Les composés **(21)** et **(23)** peuvent être obtenus commercialement. Alternativement, le composé **(21)** peut être synthétisé selon le procédé décrit dans F.H. Allen et L. Gilman (J. Am. Chem. Soc. 58 (1936) 937). Le procédé de synthèse décrit dans Allen et Gilman peut être modifié pour fournir les dérivés décrits ci-dessus en utilisant convenablement, par exemple, des composés aryles substitués à la place de composés aryles non substitués.

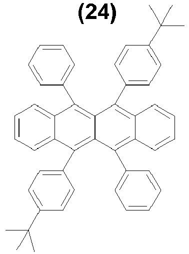

Des exemples de tels composés substitués préférés sont **(25)**, **(26)** et **(27)** 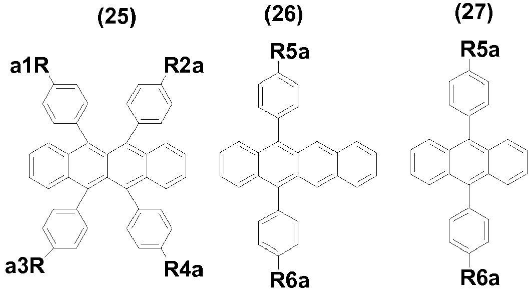 R1a, R2a, R3a, R4a, R5a et R6a sont indépendamment sélectionnés parmi l'hydrogène ou des groupes alkyles C₁-₂₀. Préférentiellement, les groupes alkyles sont des groupes alkyles C₂-₁₅, plus préférentiellement C₄-₁₂.

Selon un premier mode de réalisation du procédé, le MSCO moléculaire (sous forme pulvérulente) est chargé dans un réservoir, puis transféré dans un dispositif assurant une fusion complète du MSCO moléculaire. Une quantité déterminée du MSCO moléculaire fondu est alors transféré dans un dispositif receptacle contenant une surface de réception du fondu.

Selon un deuxième mode de réalisation, les poudres de MSCO moléculaires sont directement placées sur la surface de réception, puis sont fondues.

La surface de réception peut être la face supérieure d'un substrat «pré-paterné», e.g. un substrat OFET ou une surface de diélectrique de grille.

La surface de réception peut être traitée pour modifier sa mouillabilité vis-à vis à vis du MSCO moléculaire. Par exemple, si cette surface est un oxyde (par exemple: SiO₂, Al₂O₃, Ta₂O₅ ...), on pourra la fonctionaliser par chimisorption d'agent de silanisation (par exemple: dérivés de la famille des trialcoxychlorosilanes pour SiO₂).

Dans tous les cas, le MSCO moléculaire est porté à une température supérieure à son point de fusion (Pf). La surface de réception a avantageusement une température supérieure au Pf.

Une fois que la couche mince du MSCO moléculaire est dans son état fondu, une étape de contrôle de son degré de structuration est alors mise en oeuvre selon l'invention.

Ce contrôle du degré de structuration est basé sur la connaissance des transitions de phases (point de fusion (P_{f}), température de cristallisation (T_{C}) etc.) du MSCO moléculaire utilisé.

Connaissant ces informations, le contrôle de la structuration de la couche mince en MSCO moléculaire peut être assuré par le contrôle de la vitesse de refroidissement de l'ensemble surface de réception + MSCO moléculaire.

Pour l'obtention d'une couche mince amorphe, une trempe peut être effectuée en passant rapidement de Pf à la température ambiante, afin de figer le désordre du fondu du MSCO moléculaire à l'état solide.

En revanche, pour obtenir des couches minces monocristallines, le refroidissement sera préférentiellement effectué par un abaissement contrôlé (aspect cinétique: profil de température et temps de résidence) de la température de l'ensemble surface de réception + MSCO moléculaire jusqu'au voisinage de la température de cristallisation T_{C} du MSCO. Cette vitesse d'abaissement de température est choisie suffisamment faible pour provoquer
- l'apparition, dans un premier temps, d'un nombre fini de germes cristallins, voire d'un seul germe cristallin, puis
- dans un deuxième temps, une croissance progressive de domaines monocristallins à partir de ce nombre fini de germes. Le contrôle de la cristallisation est en particulier fonction de la structure chimique du MSCO moléculaire et du protocole de refroidissement ;
- éventuellement, un retour à la température ambiante de l'ensemble surface de réception + MSCO moléculaire monocristallin par un profil de refroidissement approprié.

Il est à noter que ce procédé est mis en oeuvre préférentiellement sous atmosphère inerte (par exemple azote (N₂) et/ou Argon (Ar)), afin d'éviter toute décomposition (par exemple par réactions d'oxydation, de réticulation chimique, d'hydrolyse ...) du MSCO moléculaire. On obtient ainsi une stabilité chimique et une intégrité du MSCO moléculaire.

Des organisations structurales intermédiaires entre l'état amorphe et l'état monocristallin peuvent être obtenues en mettant en oeuvre des profils de température intermédiaires entre la trempe et le profil de cristallisation.

Une couche mince ayant une organisation structurelle souhaitée est ainsi obtenue.

Enfin, la couche mince en MSCO moléculaire supportée par la surface de réception ou substrat est extraîte du receptacle.

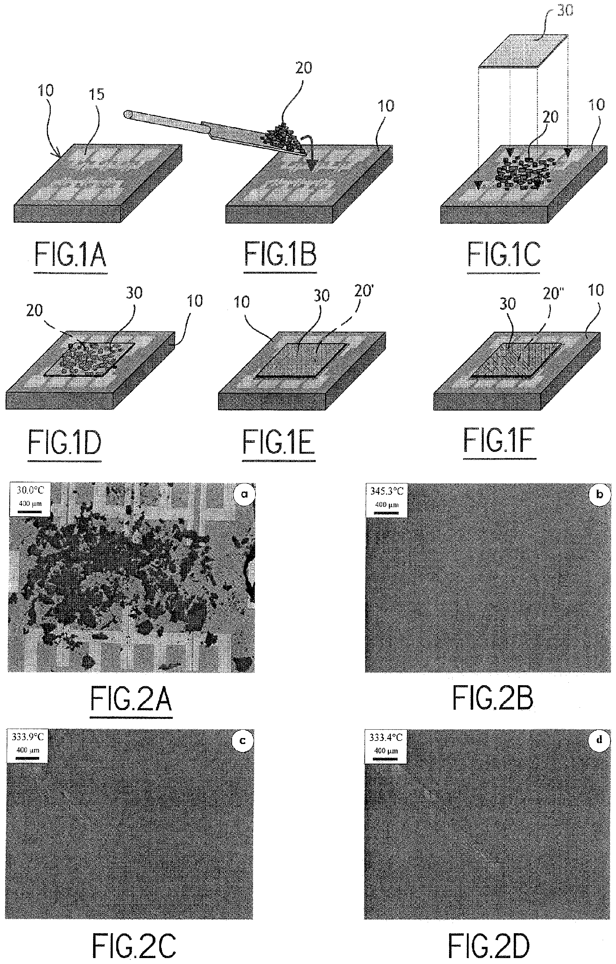

En référence aux figures 1A à 1F, sont représentées les différentes étapes d'un procédé particulier pour fabriquer un composant comportant une couche mince en MSCO moléculaire monocristallin.

Il est à remarquer que ce procédé a été testé et validé par les inventeurs.

En référence à la figure 1A, un substrat pré-patterné 10 est fourni. Ce substrat 10 peut être pré-patterné afin de comporter un ou plusieurs composants 15. Par exemple, chaque composant 15 a une structure de type transistor réalisé à partir d'un substrat de silicium dopé (contact de grille arrière), sur laquelle une couche d'oxyde de silicium (SiO₂, isolant de grille) a été formée par voie thermique, et sur laquelle des contacts (source et drain) en Ti/Au ont été évaporés. Il s'agit donc d'une configuration de "grille arrière" et de "bottom contacts" (avec des distances de gap source-drain de l'ordre 4 microns à quelques dizaines de microns),

Ce substrat 10 est ensuite logé dans un receptacle.

Le tout est par exemple placé dans un four, par exemple multi-zones à mode de chauffage par induction, ou par micro-ondes, ou par courant électrique.

Ce four est en outre muni de moyens de contrainte mécanique apte à venir contraindre le contenu du réceptacle (i.e. le substrat 10) selon une direction verticale - le réceptacle étant dans une position horizontale.

En référence à la figure 1B, un MSCO moléculaire est déposé sous une forme pulvérulente (e.g. poudre 20 plus ou moins divisée), par exemple à température ambiante.

En référence aux figures 1C et 1D, ledit moyen de contrainte mécanique vient alors contraindre la poudre 20 en pression contre le substrat 10.

Ici, l'extrémité du moyen de contrainte est représentée par une lame 30, par exemple en verre, venant en contact avec la poudre 20.

En référence à la figure 1E, un traitement thermique sous gaz neutre (par exemple N₂ et/ou Ar) est mis en oeuvre dans le four, de sorte que la température devienne égale au Pf du MSCO moléculaire. Le MSCO moléculaire passe alors dans son état fondu 20'.

En référence à la figure 1F, un refroidissement est mis en oeuvre, jusqu'à température ambiante, suivant un profil adapté, vers la T_{C} du MSCO moléculaire afin d'obtenir une couche mince 20" monocristalline, dont l'organisation structurale est contrôlée.

Afin de contrôler le profil de température, la lame 30 peut posséder des systèmes de régulation de température asservis. Il est ainsi possible d'agir sur la température du MSCO moléculaire en régulant la température de cette lame 30, en fonction par exemple de mesures de température réalisées par ailleurs dans l'enceinte du four. Par ce moyen, la température et la vitesse de refroidissement du MSCO moléculaire 20' peuvent être contrôlées avec précision.

Dans cet exemple, c'est un dispositif d'électronique organique de type OFET, ayant comme couche active la couche mince monocristalline de MSCO moléculaire 20', qui est finalement réalisé.

Dans le procédé selon l'invention, la poudre 20 est fondue à part et amenée dans le four, par exemple par l'intermédaire d'un conduit axial dont est muni le moyen de contrainte mécanique et dont l'ouverture est commandée par une vanne. Le moyen de contrainte peut-être ainsi, par exemple, comme dans une presse à injecter ou une extrudeuse, une mono-vis ou une bi-vis.

Dans ce cas, et avantageusement, le four sera porté au préalable à une température égale à Pf afin de maintenir le substrat 10 à cette température, de sorte que le MSCO moléculaire dans son état fondu ne subissent pas un choc de température à son arrivée, susceptible d'empêcher par la suite la formation d'une haute qualité structurale. Le procédé selon l'invention permet de mieux contrôler la quantité de MSCO moléculaire fourni.

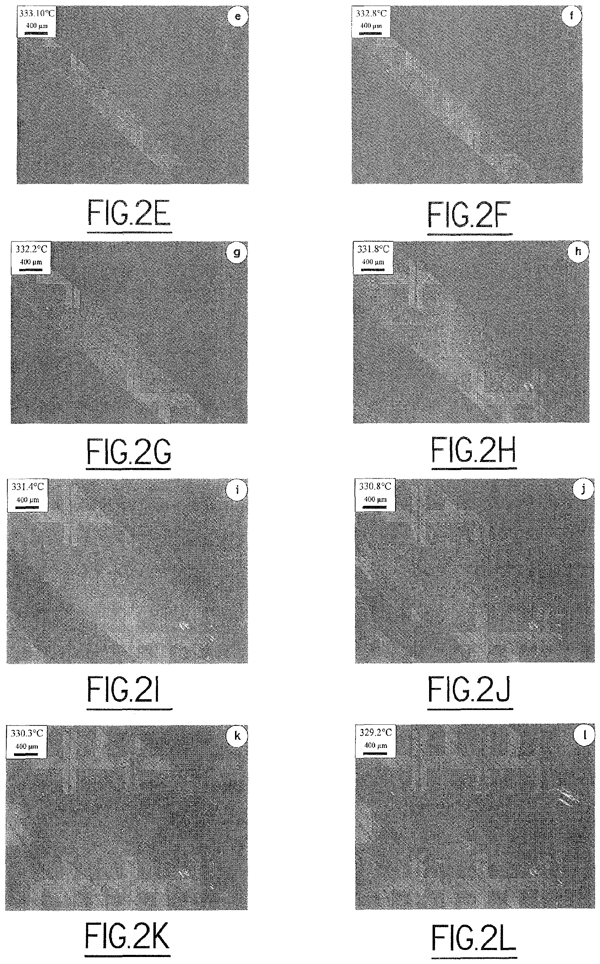

En référence aux figures 2A à 2N, des photos prises par TMOP en mode réflexion représentent différentes étapes de réalisation d'une couche mince monocristalline 20 en rubrène (MSCO moléculaire de la famille des oligo(acène)s) sur un substrat pré-patterné 10 pour OFET.
La figure 2A montre la poudre sur le substrat 20 à température ambiante.
La figure 2B montre que, à T = 345,3°C, le rubrène est dans son état fondu (P_{f} = 334°C). Il apparaît ici que le rubrène fondu est opaque lors d'observations par TMOP (e.g. thermomicroscopie otique sous polariseurs croisées) en mode réflexion, si bien que le substrat 10 "disparaît".

En référence aux figures 2C à 2L, la température est abaissée de 345,3°C à 329,2°C à une vitesse de 5°C/min. A chaque photo (montrant l'état structural à différentes températures entre ces deux valeurs extrêmes), on voit apparaître des domaines monocristallins qui croissent au fur et à mesure du temps et de la diminution en température, et ce sans qu'il y ait eu besoin d'ajouter d'additif au MSCO moléculaire pur. Il apparaît ici que le rubrène monocristallin est biréfringent lors de l'observation par TMOP en mode réflexion, si bien que le substrat 10 "réapparaît" à travers la couche mince aux endroits où se forment les domaines monocristallins. Les inventeurs en ont déduit que, à partir de l'analyse des Figures 2B et 2C, un unique germe monocristallin est apparu entre les températures de 345,3°C et 333,9°C, puisqu'un premier domaine monocristallin apparaît sur la photo 2C.

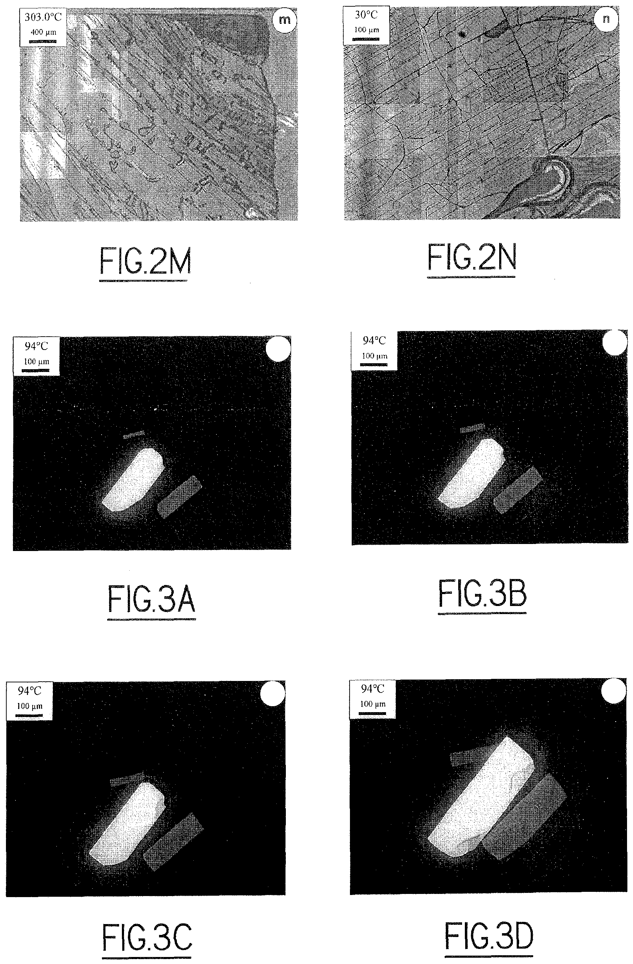

En référence aux figures 2M à 2N, la température est ramenée à la température ambiante (30°C) à une vitesse de 5°C/min - la figure 2M représentant l'état de la couche mince 20 à 303°C. Les domaines monocristallins apparaissent clairement par transparence (ils sont délimités par les lignes sombres dans l'épaisseur de la couche mince).

En référence à la figure 2N, on obtient un OFET opérationnel comportant une couche mince active monocristalline en rubrène.

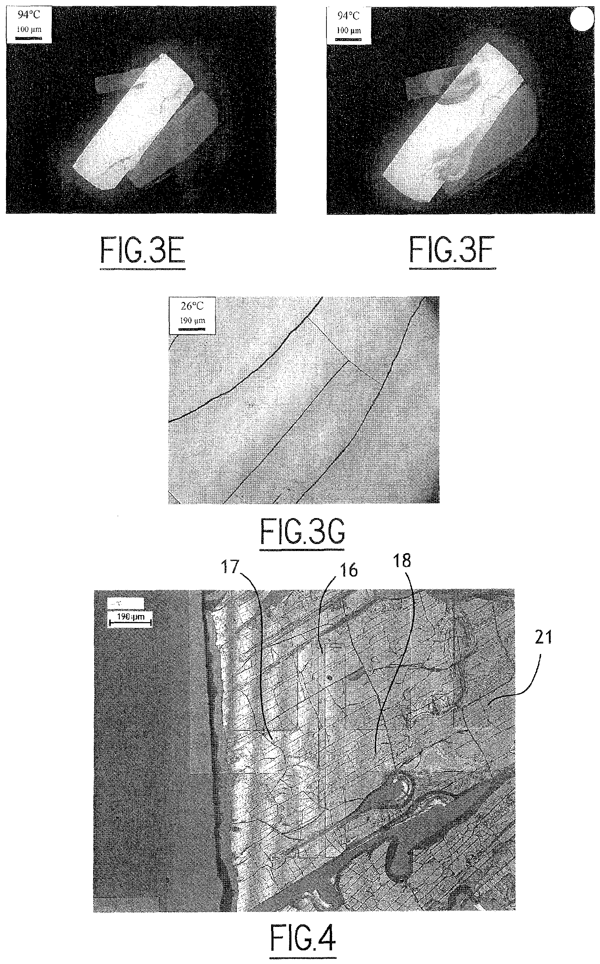

En référence aux figures 3A à 3F, des photos prises en TMOP en mode transmission représentent différentes étapes de réalisation selon l'invention d'une couche mince 20 monocristalline en α-terthiényle (MSCO moléculaire de la famille des oligo(thiophène)s) sur une surface en verre.

Le α-terthiényle est d'abord porté à une température égale à son point de fusion (Pf = 94°C).

En référence aux figures 3A à 3E, la température est maintenue à Pf. A chaque photo (montrant l'état structural à différents temps de refroidissement), on voit apparaître des domaines monocristallins (parties claires, les parties sombres étant constituées du fondu du α-terthiényle) qui croissent au fur et à mesure du temps.

En référence à la figure 3F, la température est ramenée à la température ambiante (30°C) à une vitesse de 2,5°C/min et on obtient une couche mince monocristalline en α-terthiényle - sur- isolant (l'isolant étant la surface de verre).

Ces images de TMOP ont été complétées par des caractérisations en Diffraction de Rayons X («DRX») et en Microscopie à Force Atomique («AFM») qui ont permis :
- de confirmer le caractère monocristallin des domaines mésoscopiques ou macroscopiques (mesures par DRX); et
- de déterminer la nature des orientations cristallines par rapport au substrat (mesures par AFM et DRX).

### Performances de transistors à effet de champ organiques réalisés selon l'invention :

La figure 4 donne une image en TMOP d'un dispositif OFET ayant un gap 16 entre la source 17 et le drain 18 de trente microns en largeur et de mille microns en longueur, recouvert d'un oxyde de grille de 100 nanomètres d'épaisseur, qui est en partie recouvert par des domaines monocristallins (partie droite 21) en couche mince de rubrène ayant tous une orientation similaire, et réalisés lors d'une croissance initiale de domaines monocristallins selon l'invention.

Lors du refroidissement, la couche monocristalline s'est divisée en monodomaines plus petits qu'initialement, étant donné que les gradients thermiques entre le substrat 10 et la couche organique 20 étaient encore trop importants lors du refroidissement, et en conséquence la totalité du gap 16 entre la source 17 et le drain 18 n'est pas couverte.

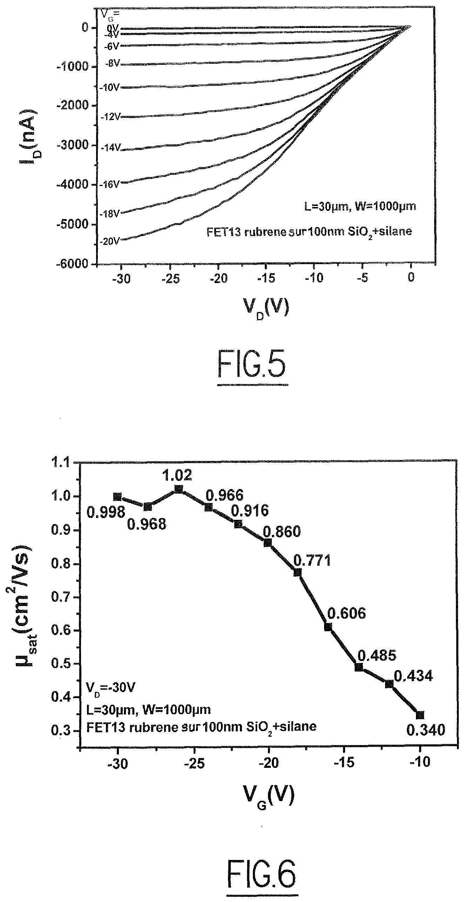

Les caractérisations électriques obtenues [caractéristiques «Courant de Drain (I_{D} [nA]) - Tension de Drain (V_{D}[V])» de la figure 5 ; et «mobilité des porteurs de charges (en régime de saturation: µₛₐₜ [cm².V⁻¹.s⁻¹]) pour une Tension Drain (V_{D} [V]) de -30 V en fonction de la tension de la grille (V_{G} [V])» de la figure 6], sont donc sous-estimées dans le cas de ce dispositif.

Les performances obtenues, en référence aux figures 5 et 6, sont cependant très honorables (e.g. équivalentes à celles de transistors à effet de champ à base de couches actives en silicium amorphe).

On notera particulièrement (Figure 5) que le dispositif est actif et passant pour des tensions de grille relativement basses compte tenu de l'épaisseur de l'oxyde de grille (100nm).

La mobilité effective (figure 6), calculée dans le régime de saturation à partir de la pente des caractéristiques I_{D}^{½}(V_{G}) (non représentées), sature vers des valeurs de l'ordre de 1.0 cm².V⁻¹.s⁻¹ pour des tensions de grille (V_{G}) de l'ordre de 25 V.

Cette valeur de mobilité est notablement élevée pour un OFET en couches minces, malgré le fait que le gap 16 source-drain ne soit pas totalement recouvert.

La valeur trouvée est donc bien en deçà d'une valeur qu'on obtiendrait avec un OFET non fissuré. En optimisant la croissance d'une couche active monocristalline de plus grande dimension, ou en réduisant la géométrie des électrodes, on peut donc raisonnablement envisager d'obtenir des mobilités (µ) atteignant des valeurs de l'ordre de quelques dizaines de cm².V⁻¹.s⁻¹ pour des couches minces monocristallines en rubrène.

C'est particulièrement probable pour des configurations où les électrodes source-drain couvrent une surface plus petite, ce qui est le cas des dispositifs intéressants les applications industrielles de type microélectronique et nano-électronique.

Un transistor à effet de champ organique (OFET), à base de couches minces monocristallines de rubrène, réalisé selon l'invention, permet donc d'atteindre des hautes performances électriques.

Ces résultats sont d'autant plus intéressants que le rubrène est un MSCO moléculaire qui reste extrêmement difficile à obtenir en couches minces monocristallines hautement organisées par les techniques conventionnelles, et que c'est un matériau très attractif - tout en étant thermostable et faiblement sensible aux effets de contamination par l'oxygène, il peut atteindre des mobilités record.

Les inventeurs ont aussi pu obtenir avec succès des couches minces monocristallines à partir de plusieurs autres MSCO moléculaires tels que le α-terthiényle, le α-sexithiényle, et le pyrène.

Par ailleurs, il faut souligner que la technique de mise en oeuvre d'une couche mince monocristalline de MSCO moléculaire selon l'invention est générique, en ce sens qu'elle est applicable à tout MSCO moléculaire congruent à son point de fusion.

D'autre part, la mise en oeuvre du procédé selon l'invention est techniquement simple, et la similarité avec les techniques de plasturgie offre des perspectives de développement de lignes de production à coûts moins élevés que dans les filières classiques de la micro/nano-électronique.

De plus, la technique selon l'invention permet d'envisager de couvrir des grandes surfaces par des couches minces à degré d'organisation structurale contrôlée (cette organisation structurale pouvant aller de la couche amorphe à la couche monocristalline), en recourant à un procédé bas coût (il s'agit en effet de la réalisation de dispositifs d'électronique et d'opto-électronique organique par des procédés similaires à ceux de la plasturgie).

## Revendications

1. Procédé de réalisation d'une couche mince en matériau semi-conducteur organique (MSCO) moléculaire destinée à être intégrée dans un dispositif pour des applications en électronique ou optoélectronique, comprenant les étapes suivantes :
(a) fournir une quantité déterminée du MSCO moléculaire sous forme d'un fondu à la surface d'un support de sorte à former une couche mince, le MSCO moléculaire étant à une température supérieure à son point de fusion ;
(b) refroidir selon un profil de température déterminé pour provoquer une solidification de la couche mince ;
**caractérisé en ce que** la température de la surface du support est supérieure ou égale au point de fusion du MSCO moléculaire au moment de mettre en oeuvre l'étape (a), et **en ce que** le profil de température de l'étape (b) comprend :
- une première partie correspondant à un refroidissement contrôlé et suffisamment lent du MSCO moléculaire jusqu'à une température voisine de la température de cristallisation du MSCO moléculaire pour ne faire apparaître qu'un seul germe dans la couche mince sous forme fondue; et
- une deuxième partie correspondant à un refroidissement contrôlé de sorte qu'au moins un domaine monocristallin croisse à partir de ce germe, la couche mince finalement obtenue étant monocristalline.

2. Procédé de réalisation d'une couche mince en MSCO moléculaire selon la revendication précédente, **caractérisé en ce qu'**il est mis en oeuvre sous atmosphère neutre.

3. Procédé de réalisation d'une couche mince en MSCO moléculaire selon l'une des revendications précédentes, **caractérisé en ce qu'**il comprend en outre, avant l'étape (a), la fourniture dudit matériau sous une forme solide, et le chauffage de ce matériau à une température supérieure à son point de fusion.

4. Procédé de réalisation d'une couche mince en MSCO moléculaire selon l'une des revendications précédentes, **caractérisé en ce que** l'étape (b) comporte l'application d'une pression sur la surface du MSCO moléculaire fondu afin de le répartir en couche mince sur la surface du support.

5. Procédé de réalisation d'une couche mince en MSCO moléculaire selon l'une des revendications précédentes, **caractérisé en ce que** l'étape (a) comprend :
- le logement dudit support dans un réceptacle d'un four ;
- un étalement du MSCO moléculaire fondu sur le support ;
- une contrainte exercée sur le MSCO moléculaire fondu pour le répartir en couche mince d'épaisseur uniforme sur la surface du support.

6. Procédé de réalisation d'une couche mince en MSCO moléculaire selon l'une des revendications précédentes, **caractérisé en ce que** le refroidissement est contrôlé lors de l'étape (b) par des moyens de régulation de la température au contact de la couche mince, asservis à un système de régulation de température du four.

7. Procédé de réalisation d'une couche mince en MSCO selon l'une des revendications précédentes, **caractérisé en ce que** le MSCO moléculaire est choisi parmi la famille des MSCO moléculaires suivante : 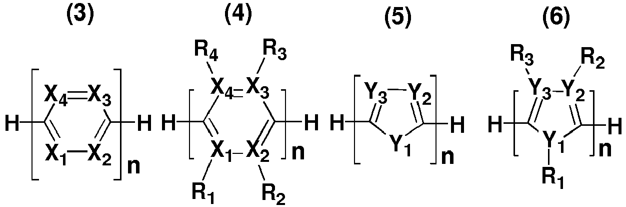 **avec n< 20 et Mw< 5000 g.mol⁻¹**
• avec un premier motif tel que **(3)** et **(4)** où X₁ = X₂ = X₃ = X₄ = C définissant par exemple le biphényle (n = 2), le terphényle (n = 3), le quaterphényle (n = 4), le quinquephényle (n = 5), le sexiphényle (n = 6) ;
• avec un deuxième motif tel que **(5)** et **(6)** où Y₁= S, Y₂ = Y₃ = C définissant par exemple le α-bisthiényle (n = 2), α-terthiényle (n = 3), α-quaterthiényle (n = 4), α-quinquethiényle (n = 5), α-sexithiényle (n = 6) ;
• avec R1, R2, R3 et R4 choisis parmi un atome d'hydrogène, un phényle, un aralkyle et une chaîne linéaire ou ramifiée, saturée ou insaturée, comportant de 1 à 6 atomes de carbone.

8. Procédé de réalisation d'une couche mince en MSCO moléculaire selon l'une des revendications 1 à 6, **caractérisé en ce que** le MSCO moléculaire est choisi parmi la famille des MSCO moléculaires suivante : 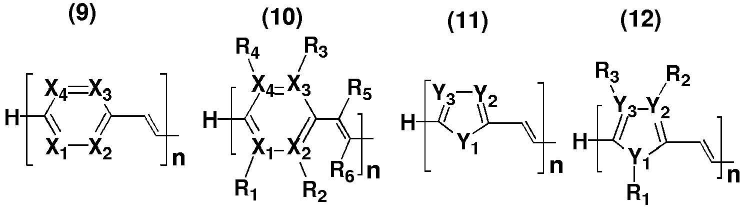 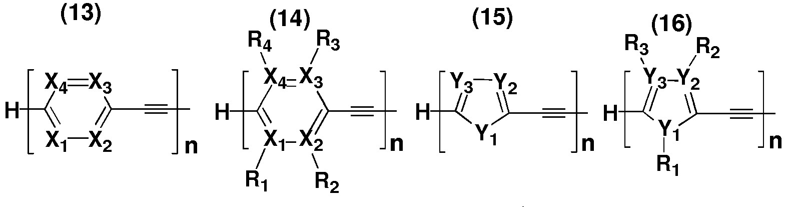 **avec n< 20 et Mw< 5000 g.mol⁻¹**
• avec un premier motif tel que **(9)-(10)** et **(13)-(14)** où X₁ = X₂ = X₃ = X₄ = C définissant par exemple, les oligo(1,4-phénylène-vinylène)s ou les oligo(1,4-phénylène-éthynylène)s en fonction de la répétition n du motif ;
• avec un deuxième motif tel que **(11)-(12)** et **(15)-(16)** où Y₁ = S, Y₂ = Y₃ = C définissant par exemple, les oligo(2,5-thiénylène-vinylène)s et les oligo(2,5-thiénylène-éthynylène)s ;
• avec R1, R2, R3 et R4 choisis parmi un atome d'hydrogène, un phényle, un aralkyle et une chaîne linéaire ou ramifiée, saturée ou insaturée, comportant de 1 à 6 atomes de carbone.

9. Procédé de réalisation d'une couche mince en MSCO moléculaire selon l'une des revendications 1 à 6, **caractérisé en ce que**. le MSCO moléculaire est choisi parmi la famille des MSCO moléculaires suivante : 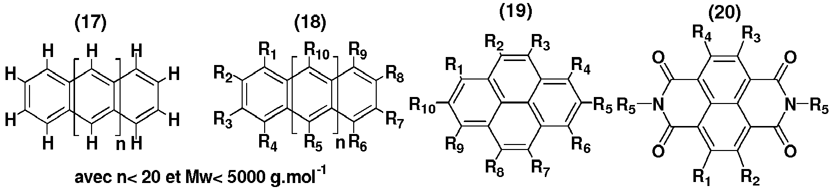
• avec un premier motif tel que **(17)** définissant par exemple le naphtalène, l'anthracène, le tétracène, le pentacène, ou l'hexacène ;
• avec un deuxième motif tel que **(18)** où **R₅** = **R₁₀** = phényle définissant par exemple le 9,10-diphenylanthracène, le 5,12-diphénylnaphtacène, ou le 5,6,11,12-tétraphénylnaphtacène encore appelé rubrène en fonction de la répétition n du motif;
• avec un troisième motif tel que **(19)** définissant par exemple le pyrène, le 1,3,6,8-tetraphénylpyrène, 1,3,6,8-tetrathiénylpyrène le chrysène le pérylène, le coronène, le terrylène, l'ovalène, le quaterrylène, ou encore des fullerènes C₆₀, C₇₀, C₇₆, C₇₈, C₈₄ ;
• avec un quatrième motif de type tel que **(20)** définissant par exemple les diimides d'acide naphtalène-1,4,5,8-tétracarboxylique, diimides d'acide anthracène-2,3,6,7-tétracarboxylique , diimides d'acide pérylène-3,4,9,10-tétracarboxylique :
• les radicaux R1 à R10 étant choisis parmi un atome d'hydrogène, un phényle, un aralkyle et une chaîne linéaire ou ramifiée, saturée ou insaturée, comportant de 1 à 6 atomes de carbone.

10. Procédé de réalisation d'une couche mince en MSCO moléculaire selon l'une des revendications 1 à 6, **caractérisé en ce que**. le MSCO moléculaire est choisi pour comprendre :
• des groupes aryle, à savoir avec le motif de base M1 où X₁ = X₂ = X₃ = X₄ = C ; et/ou
• des groupes hétéroaryle, à savoir avec le motif de base M1 où X1 = X₂ = X₃ = X₄ = C, ou O, ou S, ou N, ou P, ou B et /ou
• des groupes de types hétérocycliques, à savoir avec le motif de base M2 où Y₁ = O, ou S, ou N, ou P, ou B et Y₂ = Y₃ = C, ou O, ou S, ou N, ou P, ou B. ; 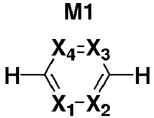 **avec X1, X2, X3 et X4**
**= C, ou O, ou S, ou N, ou P, ou B** 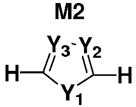 **avec Y1= O, ou S, ou N, ou P, ou B**
**avec Y2 et Y3=**
**C, ou O, ou S, ou N, ou P, ou B**

11. Procédé de réalisation d'un transistor à effet de champ organique, tel qu'un OFET, **caractérisé en ce qu'**il comprend les étapes suivantes :
(a) la fourniture d'un substrat pré-patterné, le substrat pré-patterné comportant une grille, un diélectrique de grille, des électrodes sources et des électrodes drains ;
(b) la réalisation d'une couche mince en MSCO moléculaire monocristallin conformément au procédé selon l'une des revendications précédentes, le substrat pré-patterné étant ledit support et la couche mince étant la couche active du transistor.

## Patentansprüche

1. Verfahren zur Herstellung einer dünnen Schicht aus molekularem organischen Halbleitermaterial (MSCO) zur Integration in eine Vorrichtung für elektronische oder optoelektronische Anwendungen, umfassend die folgenden Schritte:
(a) Bereitstellen einer bestimmten Menge an molekularem MSCO in Form einer Schmelze auf der Oberfläche eines Trägers, so dass eine dünne Schicht gebildet wird, wobei das molekulare MSCO eine Temperatur aufweist, die höher ist als sein Schmelzpunkt;
(b) Abkühlen entlang eines vorbestimmten Temperaturprofils, um eine Verfestigung der dünnen Schicht herbeizuführen;
**gekennzeichnet dadurch, dass** die Temperatur der Oberfläche des Trägers höher ist oder gleich dem Schmelzpunkt des molekularen MSCO in dem Moment, in dem Schritt (a) durchgeführt wird, und dadurch, dass das Temperaturprofil von Schritt (b) umfasst:
- einen ersten Teil entsprechend einer kontrollierten und ausreichend langsamen Abkühlung des molekularen MSCO bis auf eine Temperatur, die nahe an der Kristallisationstemperatur des molekularen MSCO ist, um das Auftreten nur eines Keims in der dünnen Schicht in geschmolzener Form zu bewirken; und
- einen zweiten Teil entsprechend einer kontrollierten Abkühlung, so dass mindestens ein monokristalliner Bereich ausgehend von diesem Keim wächst und die schließlich erhaltene dünne Schicht monokristallin ist.

2. Verfahren zur Herstellung einer dünnen Schicht aus molekularem MSCO gemäß dem vorstehenden Anspruch, **gekennzeichnet dadurch, dass** es in neutraler Atmosphäre durchgeführt wird.

3. Verfahren zur Herstellung einer dünnen Schicht aus molekularem MSCO gemäß einem der voranstehenden Ansprüche, **gekennzeichnet dadurch, dass** es des Weiteren, vor Schritt (a), die Bereitstellung dieses Materials in fester Form und die Erhitzung dieses Materials auf eine Temperatur höher als sein Schmelzpunkt umfasst.

4. Verfahren zur Herstellung einer dünnen Schicht aus molekularem MSCO gemäß einem der voranstehenden Ansprüche, **gekennzeichnet dadurch, dass** Schritt (b) die Applikation von Druck auf die Oberfläche des geschmolzenen molekularen MSCO zwecks seiner Verteilung als eine dünne Schicht auf der Oberfläche des Trägers umfasst.

5. Verfahren zur Herstellung einer dünnen Schicht aus molekularem MSCO gemäß einem der voranstehenden Ansprüche, **gekennzeichnet dadurch, dass** Schritt (a) umfasst:
- die Unterbringung des Trägers in einem Behälter eines Ofens;
- die Ausbreitung des geschmolzenen molekularen MSCO auf dem Träger;
- das Ausüben von Druck auf das geschmolzene molekulare MSCO, um es in einer dünnen Schicht gleichmäßiger Dicke auf der Oberfläche des Trägers zu verteilen.

6. Verfahren zur Herstellung einer dünnen Schicht aus molekularem MSCO gemäß einem der voranstehenden Ansprüche, **gekennzeichnet dadurch, dass** die Abkühlung bei Schritt (b) durch Instrumente zur Temperaturregulierung in Kontakt mit der dünnen Schicht kontrolliert wird, die durch ein System zur Temperaturregulierung des Ofens gesteuert werden.

7. Verfahren zur Herstellung einer dünnen Schicht aus molekularem MSCO gemäß einem der voranstehenden Ansprüche, **gekennzeichnet dadurch, dass** das molekulare MSCO ausgewählt ist aus der folgenden Familie molekularer MSCO: 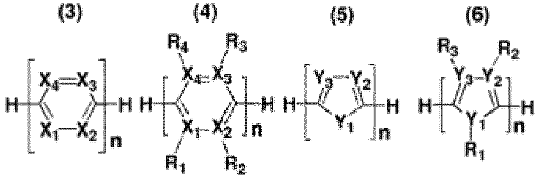 mit n<20 und Mw<5000 g.mol⁻¹
• mit einer ersten Einheit wie **(3)** und **(4)**, wobei X₁ = X₂ = X₃ = X₄ = C, die zum Beispiel Biphenyl (n = 2), Terphenyl (n = 3), Quaterphenyl (n = 4), Quinquephenyl (n = 5), Sexiphenyl (n = 6) definiert;
• mit einer zweiten Einheit wie **(5)** und **(6)**, wobei Y₁ = S, Y₂ = Y₃ = C, die zum Beispiel α-Bisthienyl (n = 2), α-Terthienyl (n = 3), α-Quaterthienyl (n = 4), α-Quinquethienyl (n = 5), α-Sexithienyl (n = 6) definiert;
• mit R1, R2, R3 und R4 ausgewählt aus einem Wasserstoffatom, einem Phenyl, einem Aralkyl und einer linearen oder verzweigten, gesättigten oder ungesättigten Kette umfassend 1 bis 6 Kohlenstoffatome.

8. Verfahren zur Herstellung einer dünnen Schicht aus molekularem MSCO gemäß einem der Ansprüche 1 bis 6, **gekennzeichnet dadurch, dass** das molekulare MSCO ausgewählt ist aus der folgenden Familie molekularer MSCO: 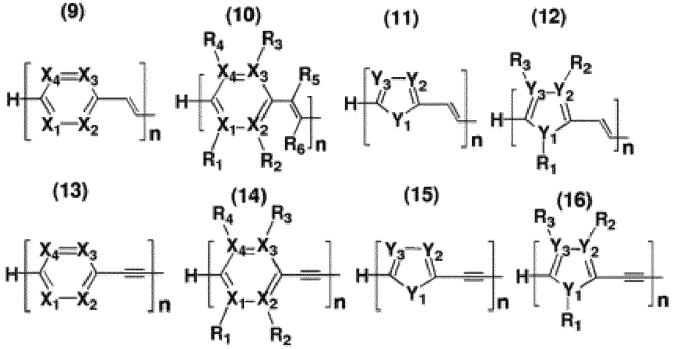 mit n<20 und Mw< 5000 g.mol⁻¹
• mit einer ersten Einheit wie **(9)-(10)** und **(13)-(14)**, wobei X₁ = X₂ = X₃ = X₄ = C, die zum Beispiel Oligo(1,4-phenylen-vinylen) oder Oligo(1,4-phenylen-ethinylen) als Funktion der Wiederholung n der Einheit definiert;
• mit einer zweiten Einheit wie **(11)-(12)** und **(15)-(16)**, wobei Y₁ = S, Y₂ = Y₃ = C, die zum Beispiel Oligo(2,5-thienylen-vinylen) und Oligo(2,5-thienylen-ethinylen) definiert;
• mit R1, R2, R3 und R4 ausgewählt aus einem Wasserstoffatom, einem Phenyl, einem Aralkyl und einer linearen oder verzweigten, gesättigten oder ungesättigten Kette umfassend 1 bis 6 Kohlenstoffatome.

9. Verfahren zur Herstellung einer dünnen Schicht aus molekularem MSCO gemäß einem der Ansprüche 1 bis 6, **gekennzeichnet dadurch, dass** das molekulare MSCO ausgewählt ist aus der folgenden Familie molekularer MSCO: 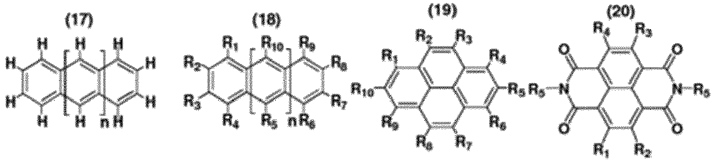 mit n<20 und Mw< 5000 g.mol⁻¹
• mit einer ersten Einheit wie **(17)**, die zum Beispiel Naphthalin, Anthracen, Tetracen, Pentacen oder Hexacen definiert;
• mit einer zweiten Einheit wie **(18)**, wobei **R₅** = **R₁₀** = Phenyl, die zum Beispiel 9,10-Diphenylanthracen, 5,12-Diphenylnaphthacen oder 5,6,11,12-Tetraphenylnaphthacen, auch Rubren genannt, als Funktion der Wiederholung n der Einheit definiert;
• mit einer dritten Einheit wie **(19)**, die zum Beispiel Pyren, 1,3,6,8-Tetraphenylpyren, 1,3,6,8-Tetrathienylpyren, Chrysen, Pyrelen, Coronen, Terrylen, Ovalen, Quaterrylen oder C₆₀-, C₇₀-, C₇₆-, C₇₈-, C₈₄-Fullerene definiert;
• mit einer vierten Einheit vom Typ wie **(20)**, die zum Beispiel Naphthalin-1,4,5,8-Tetracarbonsäurediimide, Anthracen-2,3,6,7-Tetracarbonsäurediimide, Perylen-3,4,9,10-Tetracarbonsäurediimide definiert;
• mit den Radikalen R1 bis R10 ausgewählt aus einem Wasserstoffatom, einem Phenyl, einem Aralkyl und einer linearen oder verzweigten, gesättigten oder ungesättigten Kette umfassend 1 bis 6 Kohlenstoffatome.

10. Verfahren zur Herstellung einer dünnen Schicht aus molekularem MSCO gemäß einem der Ansprüche 1 bis 6, **gekennzeichnet dadurch, dass** das molekulare MSCO ausgewählt ist, um zu umfassen:
• Arylgruppen, und zwar mit der Basiseinheit M1, wobei X₁ = X₂ = X₃ = X₄ = C; und/oder
• Heteroarylgruppen, und zwar mit der Basiseinheit M1, wobei X₁ = X₂ = X₃ = X₄ = C, oder O, oder S, oder N, oder P, oder B und/oder
• Gruppen heterocyclischer Arten, und zwar mit der Basiseinheit M2, wobei Y₁ = O, oder S, oder N, oder P, oder B und Y₂ = Y₃ = C, oder O, oder S, oder N, oder P oder B. 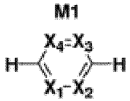 mit X1, X2, X3 und X4
= C, oder O, oder S, oder N, oder P, oder B 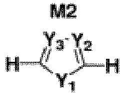 mit Y1 = O, oder S, oder N, oder P,
oder B
mit Y2 und Y3 = C, oder O, oder S, oder N, oder P, oder B

11. Verfahren zur Herstellung eines organischen Feldeffekttransistors, wie einem OFET, **gekennzeichnet dadurch, dass** es die folgenden Schritte umfasst:
(a) die Bereitstellung eines vorstrukturierten Substrats, wobei das vorstrukturierte Substrat ein Gate, ein Gate-Dielektrikum, SourceElektroden und Drain-Elektroden umfasst;
(b) die Herstellung einer dünnen Schicht aus monokristallinem, molekularem MSCO gemäß dem Verfahren gemäß einem der voranstehenden Ansprüche, wobei das vorstrukturierte Substrat der Träger ist und die dünne Schicht die aktive Schicht des Transistors ist.

## Claims

1. Method of forming a thin film of molecular organic semiconductor material (OSCM) for integration into a device for applications in electronics or optoelectronics, comprising the following steps:
(a) providing a specified amount of the molecular OSCM in the form of a melt on the surface of a carrier so as to form a thin film, the molecular OSCM being at a temperature above its melting point;
(b) cooling in accordance with a specified temperature profile in order to cause solidification of the thin film;
**characterised in that** the temperature of the surface of the carrier is above or equal to the melting point of the molecular OSCM at the time at which step (a) is carried out, and **in that** the temperature profile of step (b) comprises:
- a first part corresponding to controlled and sufficiently slow cooling of the molecular OSCM to a temperature close to the crystallisation temperature of the molecular OSCM in order to cause the appearance of only a single seed in the thin film in the molten state; and
- a second part corresponding to controlled cooling so that at least one monocrystalline domain grows starting from that seed, the thin film finally obtained being monocrystalline.

2. Method of forming a thin film of molecular OSCM according to the preceding claim, **characterised in that** it is carried out under a neutral atmosphere.

3. Method of forming a thin film of molecular OSCM according to any one of the preceding claims, **characterised in that** it further comprises, before step (a), providing said material in a solid form and heating that material to a temperature above its melting point.

4. Method of forming a thin film of molecular OSCM according to any one of the preceding claims, **characterised in that** step (b) comprises applying a pressure to the surface of the molten molecular OSCM in order to distribute it in a thin film over the surface of the carrier.

5. Method of forming a thin film of molecular OSCM according to any one of the preceding claims, **characterised in that** step (a) comprises:
- housing said carrier in a receptacle of an oven;
- spreading the molten molecular OSCM over the carrier;
- a pressure exerted on the molten molecular OSCM in order to distribute it in a thin film of uniform thickness over the surface of the carrier.

6. Method of forming a thin film of molecular OSCM according to any one of the preceding claims, **characterised in that** cooling is controlled in step (b) by temperature-regulating means in contact with the thin film, controlled by a system for regulating the temperature of the oven.

7. Method of forming a thin film of OSCM according to any one of the preceding claims, **characterised in that** the molecular OSCM is chosen from the following family of molecular OSCMs: 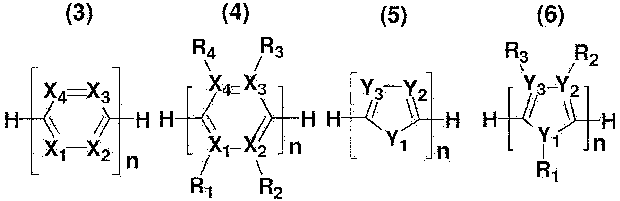 **where n < 20 and Mw < 5000 g.mol⁻¹**
• with a first motif such as **(3)** and **(4)** wherein X₁ = X₂ = X₃ = X₄ = C defining, for example, biphenyl (n = 2), terphenyl (n = 3), quaterphenyl (n = 4), quinquephenyl (n = 5), sexiphenyl (n = 6);
• with a second motif such as **(5)** and **(6)** wherein Y₁ = S, Y₂ = Y3 = C defining, for example, α-bisthienyl (n = 2), α-terthienyl (n = 3), α-quaterthienyl (n = 4), α-quinquethienyl (n = 5), α-sexithienyl (n = 6);
• with R1, R2, R3 and R4 chosen from a hydrogen atom, a phenyl, an aralkyl and a linear or branched, saturated or unsaturated chain containing from 1 to 6 carbon atoms.

8. Method of forming a thin film of molecular OSCM according to any one of claims 1 to 6, **characterised in that** the molecular OSCM is chosen from the following family of molecular OSCMs: 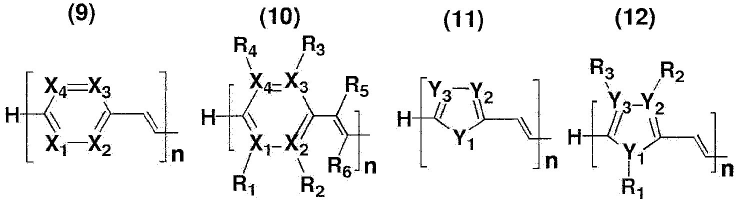 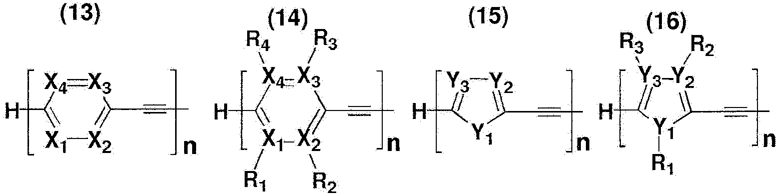 **where n** < **20 and Mw** < **5000 g.mol⁻¹**
• with a first motif such as **(9)-(10)** and **(13)-(14)** wherein X₁ = X₂ = X₃ = X₄ = C defining, for example, oligo(1,4-phenylene-vinylene)s or oligo(1,4-phenylene-ethynylene)s, depending on the repetition n of the motif;
• with a second motif such as **(11)-(12)** and **(15)-(16)** wherein Y₁ = S, Y₂ = Y₃ = C defining, for example, oligo(2,5-thienylene-vinylene)s and oligo(2,5-thienylene-ethynylene)s;
• with R1, R2, R3 and R4 chosen from a hydrogen atom, a phenyl, an aralkyl and a linear or branched, saturated or unsaturated chain containing from 1 to 6 carbon atoms.

9. Method of forming a thin film of molecular OSCM according to any one of claims 1 to 6, **characterised in that** the molecular OSCM is chosen from the following family of molecular OSCMs: 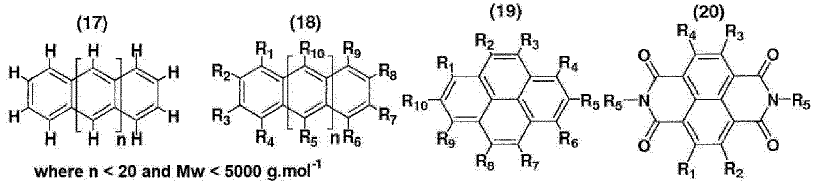
• with a first motif such as **(17)** defining, for example, naphthalene, anthracene, tetracene, pentacene or hexacene;
• with a second motif such as **(18)** wherein R₅ = R₁₀ = phenyl defining, for example, 9,10-diphenylanthracene, 5,12-diphenylnaphthacene or 5,6,11,12-tetraphenylnaphthacene, also called rubrene, depending on the repetition n of the motif;
• with a third motif such as **(19)** defining, for example, pyrene, 1,3,6,8-tetraphenylpyrene, 1,3,6,8-tetrathienylpyrene, chrysene, perylene, coronene, terrylene, ovalene, quaterrylene or C₆₀, C₇₀, C₇₆, C₇₈, C₈₄ fullerenes;
• with a fourth motif of the type such as **(20)** defining, for example, naphthalene-1,4,5,8-tetracarboxylic acid diimides, anthracene-2,3,6,7-tetracarboxylic acid diimides, perylene-3,4,9,10-tetracarboxylic acid diimides;
• the radicals R1 to R10 being chosen from a hydrogen atom, a phenyl, an aralkyl and a linear or branched, saturated or unsaturated chain containing from 1 to 6 carbon atoms.

10. Method of forming a thin film of molecular OSCM according to any one of claims 1 to 6, **characterised in that** the molecular OSCM is chosen to comprise:
• aryl groups, namely with the basic motif M1 wherein X₁ = X₂ = X₃ = X₄ = C; and/or
• heteroaryl groups, namely with the basic motif M1 wherein X₁ = X₂ = X₃ = X₄ = C, or O, or S, or N, or P, or B; and/or
• heterocyclic-type groups, namely with the basic motif M2 wherein Y₁ = O, or S, or N, or P, or B and Y₂ = Y₃ = C, or O, or S, or N, or P, or B; 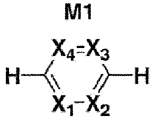 **where X1, X2, X3 and X4**
**= C, or O, or S, or N, or P, or B** 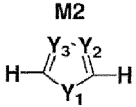 **where Y1 = O, or S, or N, or P, or B**
**where Y2 and Y3 =**
**C, or O, or S, or N, or P, or B**

11. Method of producing an organic field-effect transistor, such as an OFET, **characterised in that** it comprises the following steps:
(a) providing a pre-patterned substrate, the pre-patterned substrate comprising a gate, a gate dielectric, source electrodes and drain electrodes;
(b) forming a thin film of monocrystalline molecular OSCM in accordance with the method according to any one of the preceding claims, the pre-patterned substrate being said carrier and the thin film being the active layer of the transistor.
